# FASCICULE DE BREVET EUROPEEN

(11) **EP 0 848 429 B1**
(45) Date de publication et mention de la délivrance du brevet: **26.02.2003**
(21) Numéro de dépôt: 97410138.8
(22) Date de dépôt: 09.12.1997
(51) Int. Cl.: H01L 29/08, H01L 29/10

(54) **Transistor bipolaire à isolement par caisson**
Bipolarer Transistor mit Wannenisolierung
Bipolar transistor with pocket isolation

(30) Priorité: 10.12.1996 FR 9615389
(43) Date de publication de la demande: 17.06.1998
(73) Titulaire: STMicroelectronics S.A., 92120 Montrouge (FR)
(72) Inventeur: Gris, Yvon, 38210 Tullins (FR)
(74) Mandataire: de Beaumont, Michel

(56) Documents cités:
- EP-A- 0 378 794
- US-A- 4 339 767
- PATENT ABSTRACTS OF JAPAN vol. 015, no. 114 (E-1047), 19 mars 1991 & JP 03 004538 A (TOSHIBA CORP), 10 janvier 1991,

## Description

La présente invention concerne le domaine de la fabrication des circuits intégrés.

Plus particulièrement, dans le domaine des circuits intégrés, les composants élémentaires doivent être séparés et plus ou moins isolés latéralement les uns des autres. La technique la plus courante pour atteindre ces résultats est la technologie dite LOCOS dans laquelle les divers composants élémentaires sont séparés par des couches d'oxyde épais formées par croissance thermique. Une autre technique qui tend à se développer est la technologie dite à isolement par caisson, couramment désignée dans la technique par le terme anglo-saxon "BOX". En technologie BOX, les intervalles entre composants élémentaires sont constitués par des tranchées creusées par gravure anisotrope dans la surface supérieure d'une plaquette de silicium monocristallin et remplies d'un isolant, habituellement de l'oxyde de silicium, la surface supérieure étant rendue plane par diverses techniques, par exemple par polissage mécano-chimique (CMP) avec arrêt sur une couche de nitrure de silicium préalablement formée au-dessus de la zone de silicium à isoler.

La présente invention concerne des circuits intégrés utilisant cette dernière technique d'isolation entre composants élémentaires.

Elle vise plus particulièrement à réaliser des transistors bipolaires de performances optimales, notamment en ce qui concerne la réduction des capacités parasites et donc la vitesse de fonctionnement de ces transistors.

Un autre objet de la présente invention est d'obtenir des transistors bipolaires à résistances d'accès réduites.

Un autre objet de la présente invention est d'obtenir des transistors bipolaires aussi petits que possible.

Un autre objet de la présente invention est de réaliser de tels transistors bipolaires par des techniques couramment utilisées dans le domaine de la fabrication des circuits intégrés.

Pour atteindre ces objets, la présente invention prévoit un transistor bipolaire à isolement latéral par caisson, dans lequel une première partie de la périphérie interne supérieure du caisson isolant est évidée et remplie de silicium polycristallin du type de conductivité de la base du transistor et une deuxième partie de la périphérie interne supérieure du caisson isolant est évidée et remplie de silicium polycristallin du type de conductivité de l'émetteur du transistor.

Selon un mode de réalisation de la présente invention, une couche d'un matériau de type SiGe est formée à l'interface entre l'îlot et le silicium polycristallin du type de conductivité de l'émetteur du transistor.

La présente invention prévoit aussi un procédé de fabrication d'un transistor bipolaire comprenant les étapes consistant à former un îlot d'une couche épitaxiée du premier type de conductivité entourée d'un caisson rempli d'isolant, graver une partie au moins de la périphérie interne supérieure du caisson par un procédé de gravure anisotrope sélectif par rapport à la couche épitaxiée pour former un évidement, remplir l'évidement de silicium polycristallin du deuxième type de conductivité, amener la surface supérieure du silicium polycristallin à être au même niveau que la surface supérieure de l'îlot, réaliser une implantation de base du deuxième type de conductivité, et déposer une deuxième couche de silicium polycristallin du premier type de conductivité sur une partie de l'îlot et de façon décalée par rapport audit évidement.

Selon un mode de réalisation de la présente invention, le procédé de fabrication d'un transistor bipolaire comprend les étapes consistant à former un îlot d'une couche épitaxiée du premier type de conductivité entourée d'un caisson rempli d'isolant, graver une première partie de la périphérie interne supérieure du caisson pour former un premier évidement, remplir le premier évidement de silicium polycristallin du deuxième type de conductivité, réaliser une implantation de base du deuxième type de conductivité, graver une deuxième partie de la périphérie interne supérieure du caisson d'oxyde pour former un deuxième évidement, et remplir le deuxième évidement de silicium polycristallin du premier type de conductivité.

Selon un mode de réalisation de la présente invention, le procédé comprend l'étape consistant à siliciurer les surfaces apparentes des régions de silicium polycristallin.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe schématique d'un transistor bipolaire à isolement par caisson de structure classique ;
la figure 2 représente un exemple de vue de dessus de la structure de la figure 1 ;
les figures 3 à 6 sont des vues en coupe schématiques représentant des étapes successives de fabrication d'un transistor bipolaire à isolement par caisson selon un mode de réalisation de la présente invention ; et
la figure 7 représente un exemple de masques utilisés pour définir la structure de la figure 6.

Dans ces diverses figures et notamment dans les vues en coupe, conformément à l'usage dans le domaine de la représentation des composants semiconducteurs, les diverses dimensions ne sont pas tracées à l'échelle.

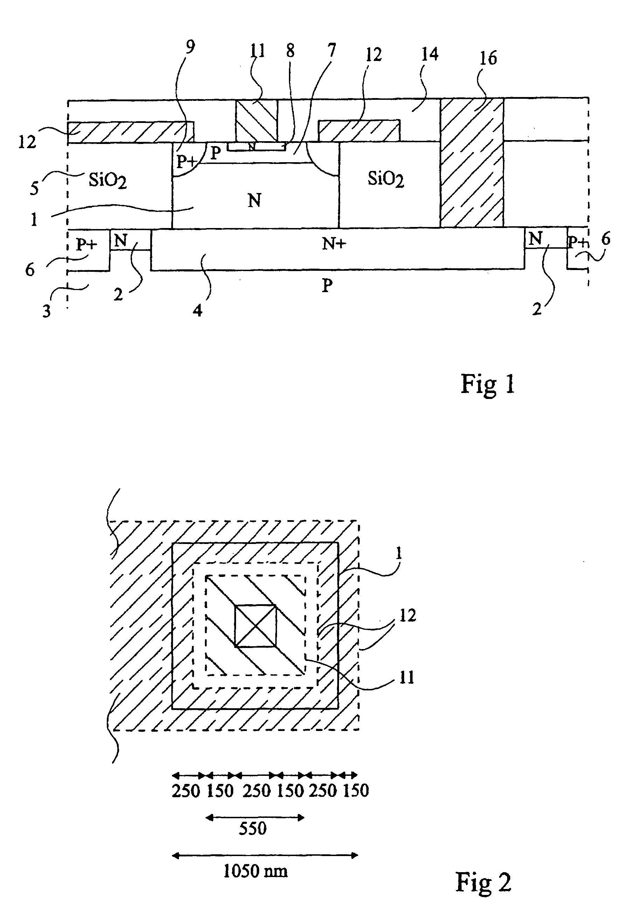

La figure 1 représente un exemple de transistor bipolaire de type NPN à isolement par caisson de structure classique.

Ce transistor est formé dans un îlot 1 d'une couche épitaxiée 2 de type N, elle-même formée sur une plaquette de silicium monocristallin 3 de type P. Une couche enterrée 4 de type N⁺ est formée à l'interface entre la couche épitaxiée et le substrat et s'étend notamment sous l'îlot 1. Cet îlot 1 est délimité latéralement par une tranchée 5 remplie d'oxyde de silicium qui l'entoure complètement. Dans la figure, la tranchée 5 s'étend jusqu'à la surface supérieure de la couche enterrée 4. Elle pourra être un peu plus ou un peu moins profonde. Il faut toutefois qu'elle ne traverse pas complètement la couche enterrée 4 car sinon on ne pourrait plus reprendre de contact de collecteur, comme on le verra ci-après. De préférence, une couche enterrée 6 de type P⁺ est formée sous l'emplacement du caisson 5 pour parfaire l'isolement latéral de l'îlot 1.

L'îlot 1 constitue le collecteur du transistor NPN et la couche enterrée 4 constitue sa région de reprise de contact de collecteur. Dans la partie supérieure de l'îlot 1 est formée une région de base 7 de type P à l'intérieur de laquelle est formée une région d'émetteur 8 de type N. Une zone périphérique 9 fortement dopée de type P constitue une région de reprise de contact de base. La région de base 7 résulte par exemple d'une implantation de bore. La région d'émetteur 8 est par exemple formée à partir d'une couche de silicium polycristallin 11 fortement dopée de type N. La région périphérique 9 de reprise de contact de base est par exemple formée à partir d'une couche de silicium polycristallin 12 fortement dopée de type P. Par exemple, avant ou après avoir formé l'implantation de base 7, on forme une couche de silicium polycristallin 12 convenablement gravée puis on dépose une couche d'oxyde de silicium 14 planarisée par tout procédé connu. La couche d'oxyde 14 est ouverte au centre de l'îlot 1 et remplie de silicium polycristallin 11. Elle est également ouverte, en même temps que la couche d'oxyde épais 5, pour former une tranchée qui rejoint la couche enterrée 4. Cette tranchée est remplie de silicium polycristallin 16 de type N⁺, par exemple en même temps que le remplissage de silicium polycristallin 11 d'émetteur. Ensuite, les contacts sont repris de façon classique sur les surfaces supérieures des éléments 11, 12 et 16.

Ce transistor souffre d'un certain nombre d'inconvénients :
- la portion de silicium polycristallin 12 présente nécessairement un défaut d'alignement par rapport à l'îlot 1 de la couche épitaxiée ;
- il se pose un problème pour le centrage de l'émetteur par rapport à la base et ceci exige la mise en oeuvre de méthodes relativement sophistiquées pour obtenir un auto-alignement ;
- la couche de silicium polycristallin de base 12 déborde nécessairement d'une certaine quantité, liée aux tolérances de positionnement au-dessus de l'îlot 1 ; il en résulte une contribution non-négligeable à la valeur de la capacité base-collecteur ; et
- le processus décrit implique nécessairement une dimension minimale possible liée aux tolérances de positionnement et aux dimensions minimales de masquage.

Les dimensions minimales de la structure de la figure 1 sont illustrées à titre d'exemple dans la vue de dessus de la figure 2 dans laquelle on a représenté les limites de masques à partir desquels sont définies diverses régions. L'îlot 1 a la forme d'un carré. Les pointillés 12 désignent les limites intérieure et extérieure de la couche de silicium polycristallin 12, le pointillé 11 désigne les limites extérieures de la couche de silicium polycristallin 11 et la croix centrale désigne un plot de contact. Dans une technologie où la dimension minimale d'un motif sur un masque est de 0,25 µm (250 nm), et où la distance de garde entre deux masques est de 0,15 µm (150 nm) on arrive aux dimensions représentées en figure 2 (en supposant que le motif de silicium polycristallin 11 est auto-aligné par rapport au motif de silicium polycristallin 12 par un espaceur) :
- surface de l'îlot 1 : 1,05 x 1,05 µm = 1,1 µm²,
- surface de l'émetteur : 0,55 x 0,55 µm ≅ 0,3 µm²,
- périmètre de l'émetteur : 550 µm x 4 = 2,2 µm.

Dans cette structure, la surface de l'îlot 1 correspond sensiblement à la surface de la jonction base-collecteur. La capacité base-collecteur (que l'on souhaite réduire pour augmenter la vitesse de fonctionnement possible du transistor) est proportionnelle à cette surface. On souhaite également réduire la surface de l'émetteur pour réduire le courant d'émetteur à densité de courant donné. On souhaite également augmenter le rapport périmètre/surface d'émetteur pour augmenter la capacité d'injection de l'émetteur à surface donnée.

Le document EP-A-0378794 décrit un procédé de fabrication d'un transistor dans un îlot à isolement par caisson dans lequel le contact de base est pris latéralement sur toute la périphérie de l'îlot.

La présente invention vise à améliorer les caractéristiques d'un transistor bipolaire et à réduire les dimensions minimales possibles d'un transistor bipolaire, d'où il résulte notamment une augmentation de la vitesse de fonctionnement de ce transistor.

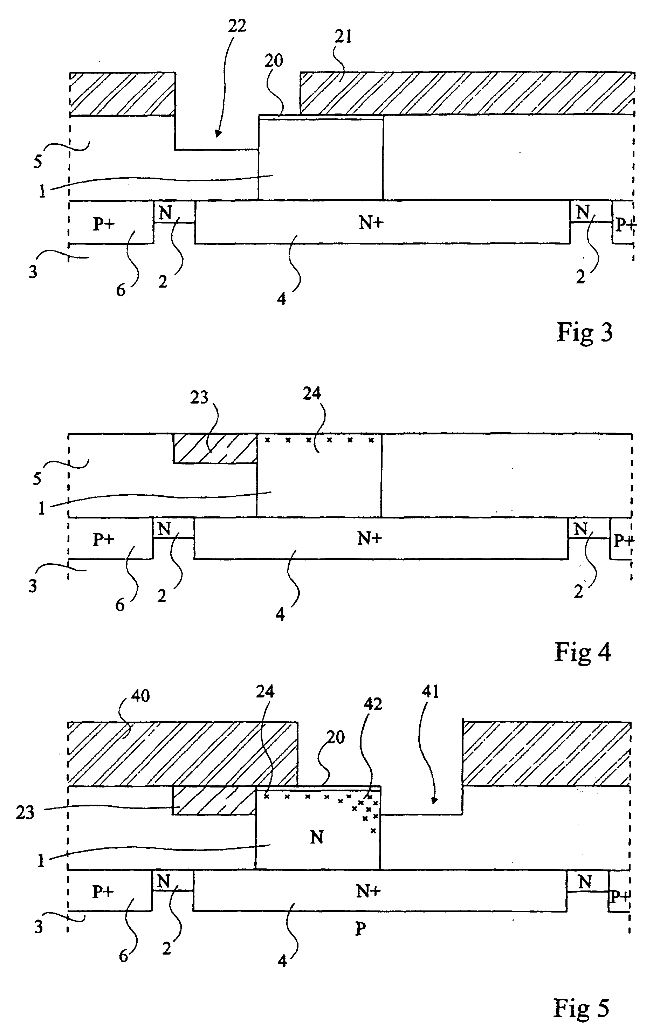

La figure 3 représente un mode de réalisation d'un transistor selon la présente invention à une étape intermédiaire de fabrication.

On part d'une structure comprenant une couche épitaxiée 2 de type N formée sur un substrat 3 de type P et comportant des couches enterrées 4 et 6 de type N⁺ et P⁺. Un îlot 1 de la couche épitaxiée, revêtu d'une couche mince 20 de nitrure de silicium, est entouré d'un caisson 5 rempli d'oxyde. Ainsi; on part de la structure obtenue immédiatement après formation des caissons d'oxyde 5. On dépose alors une couche d'un produit photosensible 21, qui sera appelé ci-après résine, et cette couche de résine est ouverte au-dessus d'au moins une portion de la périphérie supérieure de l'îlot 1. Cette ouverture s'étend par exemple le long d'un côté de l'îlot 1. On procède ensuite à une gravure anisotrope de l'oxyde de silicium, en utilisant un plasma de gravure sélectif pour la gravure de l'oxyde de silicium par rapport à la gravure du nitrure de silicium 20 et du silicium monocristallin de l'îlot 1. On forme ainsi un évidement 22 qui s'étend sur une partie seulement de l'épaisseur de la couche d'oxyde de silicium 5 le long d'au moins un bord de la périphérie de l'îlot 1.

A l'étape suivante illustrée en figure 4, on enlève la couche de résine 21, on dépose une couche de silicium polycristallin et on la regrave par tout procédé connu pour obtenir une portion de silicium polycristallin 23 dopée de type P remplissant l'évidement 22 et dont la surface supérieure est dans le plan de la surface supérieure de l'îlot 1. De préférence, la gravure du silicium polycristallin s'effectue par un polissage mécano-chimique qui s'arrête sur la couche de nitrure de silicium 20, cette couche 20 étant éliminée à une étape ultérieure.

On procède ensuite à une implantation d'un dopant de type P sur toute la surface du composant pour obtenir une implantation de dopant 24 de type P à la surface supérieure de l'îlot 1. Cette implantation servira à former la base intrinsèque du transistor.

A l'étape suivante, illustrée en figure 5, on forme sur la structure une couche de résine 40 ouverte d'un côté de l'îlot 1 opposé à celui où a été formée la zone de silicium polycristallin de base 23. Par une gravure sélective de l'oxyde de silicium par rapport au silicium et au nitrure de silicium, on grave une partie de l'épaisseur de la couche d'oxyde de silicium épais 5 du côté opposé à la région 23. De préférence, on profite de la présence de la couche de résine 40 pour réaliser une implantation, de préférence une implantation oblique, d'un dopant de type P dans la surface supérieure et sur un flanc de l'îlot 1, plus profondément que le dopage 24 susmentionné. Les dopants ainsi formés dans l'îlot 1 sont désignés par la référence 42.

Aux étapes suivantes dont le résultat est illustré en figure 5, on remplit l'évidement 41 de silicium polycristallin 43 dopé de type N, de la même manière que l'on a rempli l'évidement 21 de silicium polycristallin 23 dopé de type P. Ainsi, après recuit, on obtient une région de contact de base 32 formée à partir du silicium polycristallin 23 et une région d'émetteur 45 formée à partir du silicium polycristallin 43. La couche de base 47 est plus profonde autour de la région 45 du fait de l'implantation latérale ou oblique décrite précédemment.

Etant donné que dans ce mode de réalisation on laisse en place la couche de nitrure de silicium 20, on peut alors procéder à une étape de siliciuration et un siliciure métallique (non représenté) se forme de façon auto-alignée sur les régions de silicium polycristallin 23 et 43. Ceci permet de réduire les résistances de contact et constitue un avantage supplémentaire.

Ensuite, on forme une couche d'oxyde de silicium 48 à travers laquelle seront percées des ouvertures et formés des contacts vers les régions 23 et 43 et la couche enterrée 4. On voit que ce procédé permet d'obtenir un transistor bipolaire de type NPN miniaturisé. En particulier, on notera que l'émetteur, qui résulte d'une diffusion latérale, peut avoir une largeur inférieure à la dimension minimale possible d'une ouverture dans un masque.

La présente invention est susceptible de nombreuses variantes et modifications qui apparaîtront à l'homme de l'art.

Uniquement à titre d'exemple, on pourra réaliser une structure ayant les caractéristiques suivantes :
- hauteur de l'îlot 1 : 0,5 µm,
- largeur de l'îlot 1 : 0,4 µm,
- profondeur des régions 23 et 43 : 0,1 et 0,2 µm,
- largeur des régions 23 et 43 : 0,25 µm,
- épaisseur de l'oxyde 28, 48 : 0,5 µm

Par ailleurs, les régions isolantes 5, 28, 48 ont été indiquées comme étant de l'oxyde de silicium. On pourra utiliser tout autre matériau ou combinaison de matériaux ayant les mêmes fonctions, c'est-à-dire être isolant et pouvoir être gravé sélectivement par rapport au silicium.

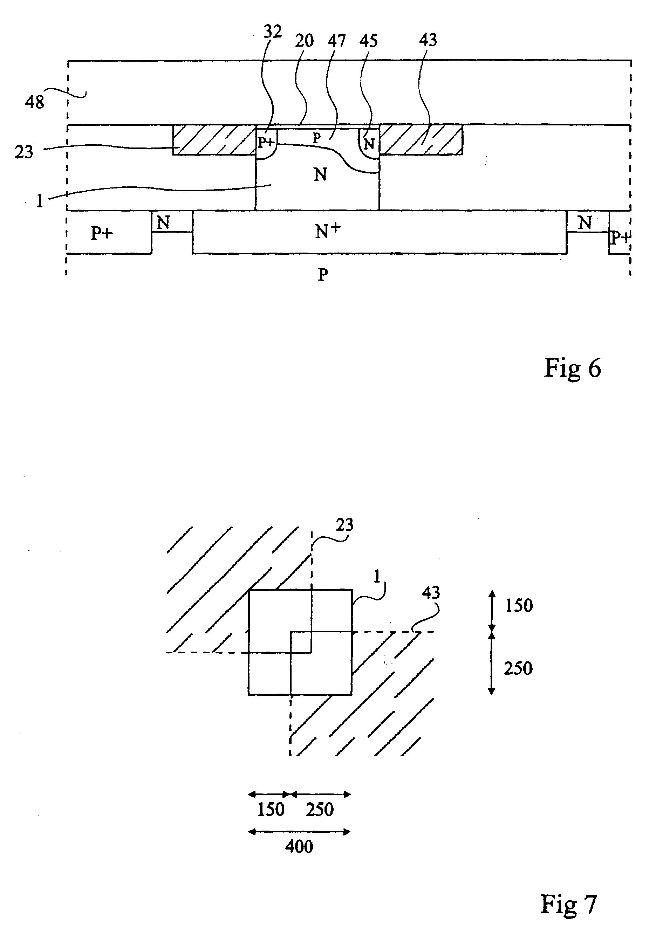

La figure 7 représente un exemple de vue de dessus dans laquelle on a représenté les limites de masques à partir desquels sont définies diverses régions du transistor de la figure 5. Le contour de l'îlot 1 est désigné par la référence 1. Les masques destinés à ouvrir les évidements dans lesquels seront disposées les régions de silicium polycristallin de base et d'émetteur 23 et 43 sont disposés sur deux coins opposés de l'îlot 1. Toujours dans les hypothèses prises dans le cas de la figure 2, on peut obtenir les dimensions minimales suivantes :
- surface de l'îlot 1 : 0,40 x 0,4 µm = 0,16 µm²,
- périmètre d'émetteur : 2 x 0,25 = 0,5 µm.

La surface active de l'émetteur au-dessus du collecteur est alors nulle.

La présente invention est susceptible de diverses variantes et modifications qui apparaîtront à l'homme de l'art. Notamment, les divers matériaux utilisés pourront être remplacés par des matériaux ayant de mêmes fonctions (dopage, caractéristiques électriques, sélectivité de gravure...).

En particulier, pour les matériaux de remplissage des évidements 22 et 41, au lieu d'utiliser simplement du silicium polycristallin fortement dopé, on pourra déposer successivement des couches de silicium polycristallin de niveaux de dopage distincts ou des matériaux de type SiGe et du silicium polycristallin.

## Revendications

1. Transistor bipolaire formé dans un îlot à isolement latéral par caisson (5), la partie supérieure de l'îlot correspondant à une couche de base, dans lequel une première partie de la périphérie interne supérieure du caisson d'isolement est évidée et remplie de silicium polycristallin (23) du type de conductivité de la base du transistor, **caractérisé en ce qu'**une deuxième partie de la périphérie interne supérieure du caisson isolant est évidée et remplie de silicium polycristallin (43) du type de conductivité de l'émetteur du transistor.

2. Transistor bipolaire selon la revendication 1, **caractérisé en ce qu'**une couche d'un matériau de type SiGe est formée à l'interface entre l'îlot et le silicium polycristallin (43) du type de conductivité de l'émetteur du transistor.

3. Procédé de fabrication d'un transistor bipolaire selon la revendication 1, **caractérisé en ce qu'**il comprend les étapes suivantes :
former un îlot (1) d'une couche épitaxiée du premier type de conductivité entourée d'un caisson (5) rempli d'isolant,
graver une première partie de la périphérie interne supérieure du caisson pour former un premier évidement (22),
remplir le premier évidement de silicium polycristallin (23) du deuxième type de conductivité,
réaliser une implantation de base (24) du deuxième type de conductivité,
graver une deuxième partie de la périphérie interne supérieure du caisson d'oxyde pour former un deuxième évidement (41), et
remplir le deuxième évidement de silicium polycristallin (43) du premier type de conductivité.

4. Procédé selon la revendication 3, **caractérisé en ce qu'**il comprend l'étape consistant à siliciurer les surfaces apparentes des régions de silicium polycristallin (23, 43).

## Claims

1. A bipolar transistor formed in a island laterally isolated by a well (5), the upper part of the island corresponding to a base layer, wherein a first portion of the upper internal periphery of the insulating well is hollowed and filled with polysilicon (23) of the conductivity type of the transistor base, to form a base contacting region, **characterized in that** a second portion of the upper internal periphery of the insulating well is hollowed and filled with polysilicon (43) of the conductivity type of the transistor emitter.

2. The bipolar transistor of claim 1, **characterized in that** a layer of an SiGe-type material is formed at the interface between the island and the polysilicon (43) of the conductivity type of the transistor emitter.

3. A method for manufacturing the bipolar transistor of claim 1, **characterized in that** it includes the following steps:
forming an island (1) of an epitaxied layer of the first conductivity type surrounded with a well (5) filled with insulator,
etching a first portion of the upper internal periphery of the well to form a first hollowed portion (22),
filling the first hollowed portion with polysilicon (23) of the second conductivity type,
performing a base implant (24) of the second conductivity type,
etching a second portion of the upper internal periphery of the oxide well to form a second hollowed portion (41), and
filling the second hollowed portion with polysilicon (43) of the first conductivity type.

4. The method of claim 3, **characterized in that** it includes the step of siliciding the apparent surfaces of the polysilicon regions (23, 43).

## Patentansprüche

1. Ein Bipolartransistor gebildet in einer Insel seitlich isoliert durch eine Vertiefung (5), wobei der Oberteil der Insel einer Basisschicht entspricht, wobei ein erster Teil des oberen Innenumfangs der isolierenden Vertiefung ausgehöhlt ist und mit Polysilizium (23) des Leitfähigkeitstyps der Transistorbasis gefüllt ist, um eine Basiskontaktierzone zu bilden, **dadurch gekennzeichnet, daß** ein zweiter Teil des oberen Innenumfangs der Isoliervertiefung ausgehöhlt ist und mit Polysilizium (43) der Leitfähigkeitstype des Transistoremitters gefüllt ist.

2. Bipolartransistor nach Anspruch 1, **dadurch gekennzeichnet, daß** eine Schicht aus einem SiGe-Typ Material an einer Grenzfläche zwischen der Insel und dem Polysilizium (43) des Leitfähigkeits des Transistoremitters gebildet ist.

3. Ein Verfahren zur Herstellung des Bipolartransistors nach Anspruch 1, **dadurch gekennzeichnet, daß** die folgenden Schritte vorgesehen sind:
Bilden einer Insel (1) aus einer Epitaxialschicht eines ersten Leitfähigkeitstyps umgeben mit einer Vertiefung (5) angefüllt mit Isolator;
Ätzen eines ersten Teils des oberen Innenumfangs der Vertiefung zur Bildung eines ersten ausgehöhlten Teils (22),
Füllen des ersten ausgehöhlten Teils mit Polysilizium (23) des zweiten Leitfähigkeitstyps,
Ausführen einer Basisimplantation (24) aus dem zweiten Leitfähigkeitstyp,
Ätzen eines zweiten Teils des oberen Innenumfangs der Oxidvertiefung zur Bildung eines zweiten ausgehöhlten Teils (41) und
Füllen des zweiten ausgehöhlten Teils mit Polysilizium (43) des ersten Leitfähigkeitstyps.

4. Verfahren nach Anspruch 3, **dadurch gekennzeichnet, daß** der Schritt der Silizidbildung (des Silizidierens) der erscheinenden Oberflächen der Polysiliziumzonen (23, 43) vorgenommen wird.
